# EUROPEAN PATENT APPLICATION

(11) **EP 1 227 361 A2**
(43) Date of publication of application: **31.07.2002**
(21) Application number: 01120900.4
(22) Date of filing: 30.08.2001
(51) Int. Cl.: G02F 1/1362

(54) **Semiconductor optical device having reduced parasitic capacitance**

(30) Priority: 30.01.2001 JP 2001021708
(71) Applicant: THE FURUKAWA ELECTRIC CO., LTD., Tokyo (JP)
(72) Inventor: Arakwa, Satoshi, c/o The Furukawa Electric Co.,Ltd, Tokyo (JP); Ikeda, Nariaki, c/o The Furukawa Electric Co., Ltd, Tokyo (JP); Yamaguchi, Takeharu, c/o The Furukawa Elec. Co.Ltd, Tokyo (JP)
(74) Representative: Pätzold, Herbert, Dr.

(57) **Abstract**

A semiconductor optical device includes a mesa stripe (22) having a layer structure, a pair of current blocking layers (24) which abut and cover respective sides of the mesa stripe (22), a pair of Al-oxidized passivation layers (42) each covering one of the current blocking layers (24), a p-side electrode (30) in contact with the top surface of the mesa stripe (22) through the opening (46) formed between the Al-oxidized layers (42).

## Description

### BACKGROUND OF THE INVENTION

### (a) Field of the Invention

The present invention relates to a semiconductor optical device having a reduced parasitic capacitance and, more particularly, to a semiconductor optical device suited for use as a semiconductor optical modulator. The present invention also relates to a method for manufacturing the same.

### (b) Description of the Related Art

Semiconductor optical modulators are widely used in the field of optical communication for transmitting optical signals. The semiconductor optical modulator is used for optical intensity modulation or optical frequency modulation to transmit an optical signal light, which modulates a carrier light. It is generally important to reduce the parasitic capacitance in the semiconductor optical modulator for improvement of higher speed operation and for reliability in the device characteristics. For this purpose, the optical modulator has a waveguide structure wherein a mesa stripe including the active layer of the modulator is abutted and covered at both sides thereof by a pair of semi-insulating InP layers doped with iron (Fe).

Along with the need for a higher-capacity and higher-speed communication in the field of the optical communication, it is desired that the optical modulator have a higher operational speed. For achieving a higher-speed modulation in the optical modulator, it is specifically desired to reduce the parasitic capacitance around the electrodes of the optical modulator.

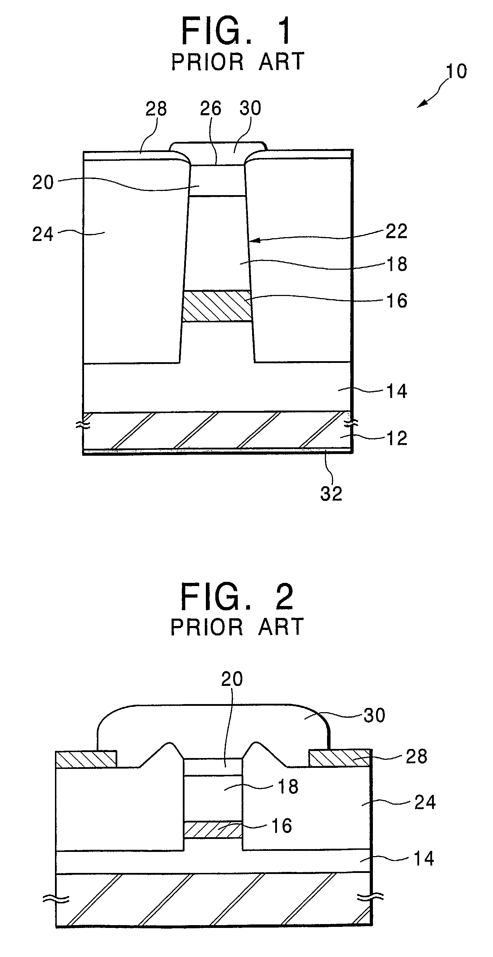

Referring to Fig. 1, a conventional optical modulator, generally designated by numeral 10, includes an n-type InP substrate (n-InP substrate) 12, and a layer structure including a 500-nm-thick n-InP lower cladding layer (buffer layer) 14 having a carrier density of 1x10¹⁸ cm⁻³, a GaInAsP-based multiple quantum well (MQW) structure or active layer structure 16, a 2000-nm-thick p-InP upper cladding layer 18 having a carrier density of 5x10¹⁷ cm⁻³, and a 500-nm-thick p-GaInAs contact layer 20 having a carrier density of 5x10¹⁸ cm⁻³, which are consecutively formed on the n-InP substrate 12.

The contact layer 20, the p-InP upper cladding layer 18, the MQW structure 16 and the top portion of the n-InP lower cladding layer 14 are configured as a mesa stripe 22, which are abutted and covered by a pair of 2500-nm-thick semi-insulating InP current blocking layers 24 at both sides of the mesa stripe 22. The top of the contact layer 20 is exposed from an opening 26 to be in contact with an overlying p-side electrode 30. A pair of passivation layers made of SiN cover the InP current blocking layers 24. An n-side electrode 32 is formed on the bottom surface of the n-InP substrate 12.

The conventional optical modulator 10 as described above uses a pair of semi-insulating current blocking layers 24 that abut and cover respective sides of the MQW structure 16. It is considered that this structure is advantageous in the reduction of the parasitic capacitance and improvement for the higher speed operation over another conventional optical modulator having a pair of current blocking layers, each implemented by a p-n junction such as p-InP/n-InP current blocking layers, which abut and cover respective sides of the MQW structure.

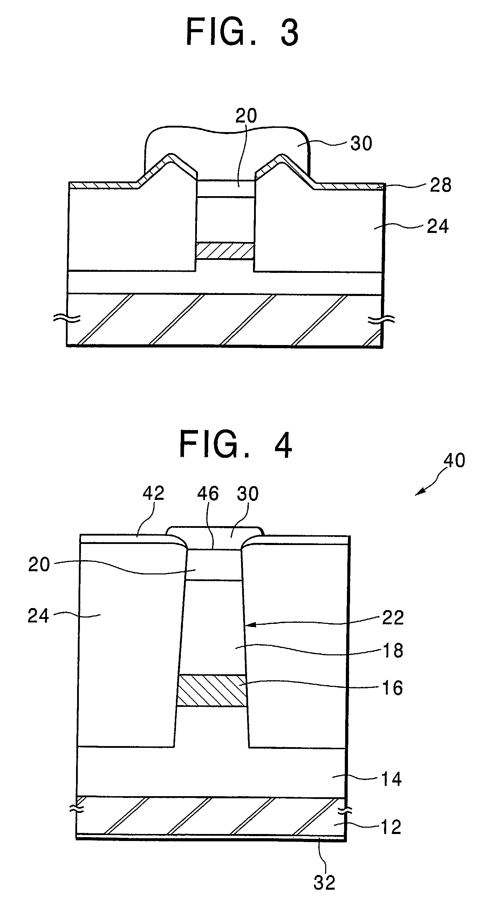

However, we have found that there is a problem in the structure of the conventional optical modulator having the semi-insulating current blocking layers, as will be detailed below with reference to Figs. 2 and 3. Fig. 2 shows the defective structure we have found around the top electrode 30 in the conventional optical modulator, and Fig. 3 shows an ideal structure for the top electrode 30 of the conventional optical modulator.

In the manufacture of the conventional optical modulator having the semi-insulating current blocking layers 24, the passivation layer 28 is subjected to patterning for forming the opening 26 to expose the contact layer 20, which is to be connected to the top electrode through the opening 26. The margin used for patterning the passivation layer 28 causes the opening 26 to expose the semi-insulating current blocking layers 24 as well as the contact layer 20. Thus, the p-side electrode 30 made of AuZn, for example, is liable to be in contact with the Fe-doped semi-insulating current blocking layers 24, as shown in Fig. 2.

More specifically, it is difficult to achieve the ideal structure for the top electrode 30 such as shown in Fig. 3, wherein the Fe-doped semi-insulating layers 24 are completely isolated from the top p-side electrode 30. This difficulty in fact limited the higher-speed operation of the optical modulator. In addition, since the p-side electrode 30 includes Zn as a constituent element thereof and the Fe-doped current blocking layers include Fe, the Zn content in the p-side electrode 30 and the Fe content in the Fe-doped semi-insulating current blocking layers 24 diffuse mutually across the interface between the p-side electrode 30 and the semi-insulating current blocking layer 24. This mutual diffusion degrades the modulation characteristics of the optical modulator.

The reduction of the parasitic capacitance around one of the electrodes may be achieved by conventional techniques using a reduced occupied area for the top electrode, and covering the area other than the contact area between the contact layer of the mesa stripe and the top electrode by using a passivation layer. However, these techniques can provide only limited advantages.

### SUMMARY OF THE INVENTION

In view of the above, it is an object of the present invention to provide a semiconductor optical device suited for use as a higher-speed optical modulator.

The present invention provides, in one aspect thereof, a semiconductor optical device including: a semiconductor substrate; a layer structure formed as a mesa stripe having sides and overlying the semiconductor substrate; a pair of current blocking layers configured to abut and cover respective sides of the mesa stripe; a pair of Al-oxidized passivation layers formed to cover respective of the pair of current blocking layers, wherein a separation between the Al-oxidized passivation layers defines an opening that exposes a top of the layer structure; a first electrode in contact with the top of the layer structure and extending through the opening; and a second electrode formed on the semiconductor substrate.

The present invention also provides, in another aspect thereof, a method for manufacturing a semiconductor optical device including the steps of: forming a mesa stripe having sides and a semiconductor layer structure overlying a semiconductor substrate; forming a selective growth mask on the mesa stripe; consecutively growing a pair of current blocking layers and a pair of Al-containing compound semiconductor layers at respective sides of the mesa stripe by using the selective growth mask; selectively oxidizing Al atoms in the Al-containing compound semiconductor layers to form Al-oxidized layers; removing the selective growth mask to form an opening that exposes a top of the mesa stripe; forming a first electrode in contact with the top of the mesa stripe through the opening; and forming a second electrode on the semiconductor substrate.

In accordance with the semiconductor optical device of the present invention and the semiconductor optical device manufactured by the method of the present invention, the parasitic capacitance involved around the first electrode can be reduced and diffusion of the constituent elements between the first electrode and the current blocking layers can be suppressed. Thus, the semiconductor optical device has a higher-operational speed and a higher reliability in the device characteristics thereof.

The above and other objects, features and advantages of the present invention will be more apparent from the following description, referring to the accompanying drawings.

### BRIEF DESCRIPTION OF THE DRAWINGS

Fig. 1 is a sectional view of a conventional optical modulator.
Fig. 2 is a sectional view of the conventional optical modulator of Fig. 1, showing the defect therein.
Fig. 3 is an ideal structure for the conventional optical modulator of Fig. 1.
Fig. 4 is a sectional view of an optical modulator according to an embodiment of the present invention.
Figs. 5A to 5E are sectional views of the optical modulator of Fig. 1 during fabrication thereof, consecutively illustrating the fabrications steps in the fabrication process.

### PREFERRED EMBODIMENT OF THE INVENTION

Now, the present invention is specifically described with reference to the preferred embodiment thereof.

Referring to Fig. 4, a semiconductor optical device according to the preferred embodiment of the present invention is implemented as a semiconductor optical modulator of a "buried heterostructure type". The optical modulator, generally designated by numeral 40, according to the present embodiment includes an n-type InP substrate (n-InP substrate) 12, and a layer structure including a 500-nm-thick n-InP lower cladding layer 14 having a carrier density of 1x10¹⁸ cm⁻³, a GaInAsP-based multiple quantum well structure (MQW) or active layer structure 16, a 2000-nm-thick p-InP upper cladding layer 18 having a carrier density of 5x10¹⁷ cm⁻³, and a 500-nm-thick p-GaInAs contact layer 20 having a carrier density of 5x10¹⁸ cm⁻³, which are consecutively formed on the n-InP substrate 12.

The contact layer 20, the p-InP upper cladding layer 18, the MQW structure 16 and the top portion of the n-InP lower cladding layer 14 are configured as a mesa stripe 22, which are abutted and covered by a pair of 2500-nm-thick semi-insulating InP current blocking layers 24 at respective sides of the mesa stripe 22. The top of the contact layer 20 is exposed from an opening 46 to be in contact with an overlying p-side electrode 30. A pair of Al-oxidized layer 42 each having a higher electric resistance cover the InP current blocking layers 24. The Al-oxidized layer is obtained by selectively oxidizing the Al atoms in an AlInAs layer. An n-side electrode 32 is formed on the bottom surface of the n-InP substrate 12.

It is to be noted that the Al-oxidized layers 42 in the embodiment replace the passivation layers made of SiN in the conventional optical modulator. The Al-oxidized layer 42 has a specific resistance as high as 10⁹ Ω-cm. The Al-oxidized layer 42 is obtained by selectively oxidizing the Al atoms in an Al-containing compound semiconductor layer, such as AlGaAs layer and AlInAs layer.

The Al-containing layer, such as AlGaAs layer and AlInAs layer, can be grown by a selective growth technique by using a selective growth mask. This allows the opening 46 for the contact layer 20 can be formed by merely removing the selective growth mask after the selective growth process, and thereby allows the margin for forming the opening to be removed. Thus, the top p-side electrode 30 which is in electric contact with the contact layer 20 is substantially completely isolated from the semi-insulating current blocking layers 24, thereby reducing the parasitic capacitance involved around the top p-side electrode 30. The process for forming the opening in a film by selectively growing the film while using a selective growth mask and removing the selective growth mask may be referred to as a self-alignment process in this text.

In addition, since the contact between the top electrode 30 and the Fe-doped current blocking layers 24 does not occur, the mutual diffusion of the Fe content in the current blocking layers 24 and the Zn content in the top electrode 30 can be removed.

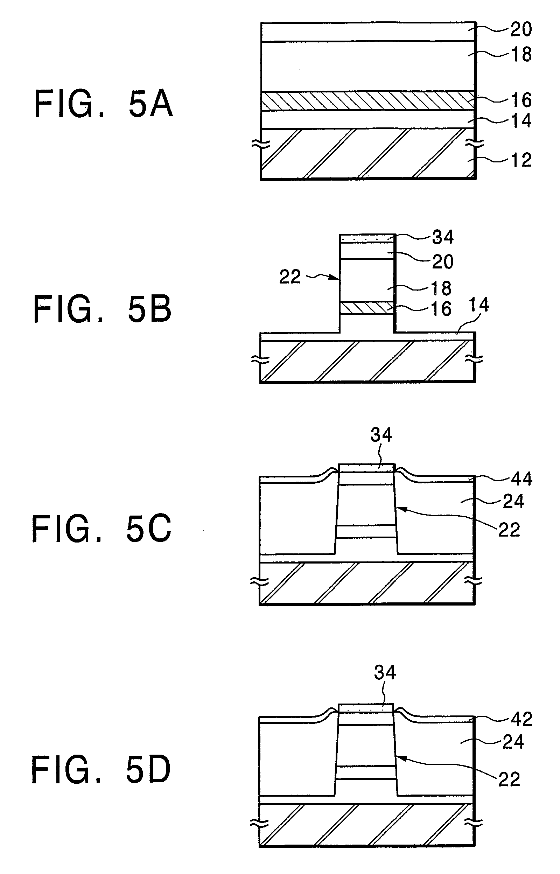

Now, fabrication of the semiconductor optical modulator of Fig. 4 will be described below with reference to Figs. 5A to 5E.

In Fig. 5A, a 500-nm-thick n-InP lower cladding layer 14, a GaInAsP-based MQW structure 16, a 2000-nm-thick p-InP upper cladding layer 18, and a 500-nm-thick p-GaInAs contact layer 20 are consecutively formed on an n-InP substrate 12 as a layer structure.

Subsequently, as shown in Fig. 5B, a stripe pattern mask 34 made of a dielectric substance such as SiN is formed on the layer structure, followed by etching the contact layer 20, upper cladding layer 18, the MQW structure 16 and a top portion of the lower cladding layer 14 to form a mesa stripe 22.

Thereafter, as shown in Fig. 5C, by using the stripe pattern mask 34 as a selective growth mask, a 500-nm-thick semi-insulating InP current blocking layer 24 is selective grown while being doped with Fe to abut and cover respective sides of the mesa stripe 22.

A 200-nm-thick AlInAs layer 44 is then selectively grown on each of the semi-insulating, Fe-doped InP current blocking layers 24.

Thereafter, as shown in Fig. 5D, the Al atoms in the AlInAs layer 44 is selectively oxidized at a high temperature in a steam ambient by using a known oxidizing process to form an Al-oxidized layer 42.

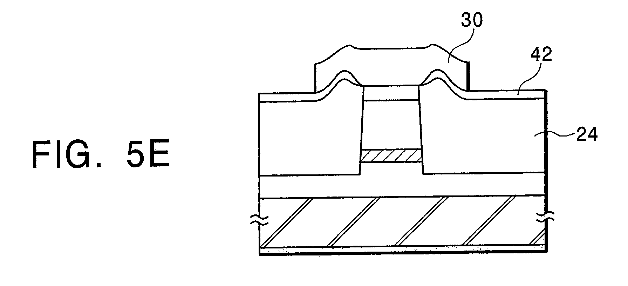

Subsequently, as shown in Fig. 5E, the stripe pattern mask 34 is removed to form an opening 46 between the Al-oxidized layers 24 in a self alignment manner, thereby exposing the contact layer 20. A p-side electrode 30 is then formed which is in direct contact with the contact layer 20 through the opening 46. An n-side electrode 32 not shown is then formed on the bottom surface of the InP substrate 12, thereby obtaining the structure of Fig. 4.

In the final structure shown in Fig. 5E, the Al-oxidized layer 42 cover the Fe-doped InP current blocking layers 24, thereby preventing the p-side electrode 30 from electrically contacting the Fe-doped InP current blocking layers 24. This improves the isolation between the p-side electrode 30 and the Fe-doped InP current blocking layers 24. In addition, the opening 46 is formed by removing the selective growth mask 34 in a self-alignment manner, which raises the production yield of the semiconductor optical modulator.

Samples of the semiconductor optical modulator of the present embodiment were fabricated by the method as described above. The samples were subjected to measurements of the modulation speed, which exhibited an operational speed corresponding to an operational frequency of about 18 GHz. A sample of the conventional optical modulator was also fabricated which included a passivation layer made of SiN formed on the InP current blocking layers 24 instead of the Al-oxidized layer 42. The sample of the conventional optical modulator had a lower operational speed corresponding to an operational frequency of 15 GHz. Thus, the sample of the present embodiment exhibited an improvement of 20% in the operational speed.

The semiconductor optical device and the method for fabricating the semiconductor optical device can be applied to another optical device such as a semiconductor laser device, and integrated optical devices such as a distributed feed-back (DFB) laser device having an EA modulator.

Since the above embodiments are described only for examples, the present invention is not limited to the above embodiments and various modifications or alterations can be easily made therefrom by those skilled in the art without departing from the scope of the present invention.

## Claims

1. A semiconductor optical device comprising: a semiconductor substrate (12); a layer structure formed as a mesa stripe (22) having sides and overlying said semiconductor substrate (12), a pair of current blocking layers (24) configured to abut and cover respective sides of said mesa stripe; a pair of Al-oxidized passivation layer (42) formed to cover respective of said pair of current blocking layers, wherein a separation between said pair of Al-oxidized passivation layers (42) defines an opening (46) that exposes a top of said layer structure; a first electrode (30) in contact with said top of said layer structure and extending through said opening (46); and a second electrode (32) formed on said semiconductor substrate (12) **characterized in that**:
said Al-oxidized passivation layer (42) is an Al-oxide layer wherein Al atoms in an Al-containing layer is selectively oxidized.

2. The semiconductor optical device as defined in claim 1, wherein: each of said current blocking layers (24) is an Fe-doped semi-insulating layer; and said first electrode (30) contains Zn.

3. The semiconductor optical device as defined in claim 1, wherein said semiconductor optical device is an optical modulator (40).

4. A method for manufacturing a semiconductor optical device comprising the steps of:
forming a mesa stripe (22) having sides and a semiconductor layer structure overlying a semiconductor substrate (12);
forming a selective growth mask (34) on said mesa stripe (22);
consecutively growing a pair of current blocking layers (24) and a pair of an Al-containing compound semiconductor layers (44) at respective sides of said mesa stripe (22) by using said selective growth mask (34);
selectively oxidizing Al atoms in said Al-containing compound semiconductor layers (44) to form Al-oxidized layers (44);
removing said selective growth mask (34) to form an opening that exposes said mesa stripe (22);
forming a first electrode (30) in contact with said mesa stripe (22) through said opening (46); and
forming a second electrode (32) on said semiconductor substrate (12).
